# EUROPEAN PATENT APPLICATION

(11) **EP 4 535 417 A1**
(43) Date of publication of application: **09.04.2025**
(21) Application number: 23815958.6
(22) Date of filing: 26.05.2023
(51) Int. Cl.: H01L 23/29, H01L 23/31, C08G 59/42, C08K 3/013, C08L 63/00, H01L 25/07, H01L 25/18

(54) **LIQUID RESIN COMPOSITION AND RESIN-ENCAPSULATED POWER MODULE**

(30) Priority: 02.06.2022 JP 2022090311; 06.02.2023 JP 2023016277
(71) Applicant: SUMITOMO BAKELITE CO., LTD., Tokyo 140-0002 (JP)
(72) Inventor: TSUNODA, Tomoki, Tokyo 140-0002 (JP); GO, Yoshiyuki, Tokyo 140-0002 (JP); INOMATA, Haruhiko, Tokyo 140-0002 (JP)
(74) Representative: Ter Meer Steinmeister & Partner
(86) International application number: PCT/JP2023/019658
(87) International publication number: WO 2023/234201

(57) **Abstract**

Provided is a liquid resin composition used for encapsulating, by a casting method, a power module which includes a substrate for a power module, over which a circuit layer is formed, and a power semiconductor element mounted over the circuit layer of the substrate for a power module, the liquid resin composition containing (A) an epoxy resin, (B) an acid anhydride, (C) a curing accelerator, (D) an inorganic filler, and (E) a sedimentation preventing agent, in which the epoxy resin (A) includes an alicyclic epoxy resin, and a viscosity of the liquid resin composition at 25°C is 75 Pa·s or less.

## Description

### TECHNICAL FIELD

The present invention relates to a liquid resin composition and a resin-encapsulated power module. More specifically, the present invention relates to a liquid resin composition for casting used for encapsulating a power semiconductor element, and a power module manufactured using the same.

### BACKGROUND ART

An epoxy resin has excellent heat resistance, chemical resistance, insulating properties, and the like, and has been used as a liquid encapsulating material for casting to encapsulate a substrate and a semiconductor element in a semiconductor device or the like.

In recent years, power semiconductor elements capable of operating at high temperatures have been developed, and the epoxy resin used as an encapsulating material thereof is also required to have a higher level of heat resistance.

In addition, an encapsulating material for a power module is required to have low linear expansion, in addition to insulating properties and heat resistance. This is to prevent cracks or peeling in an encapsulating resin due to expansion caused by heat generated from the power semiconductor element. In order to reduce the coefficient of linear expansion, it is common practice to add an inorganic filler to the encapsulating resin (for example, Patent Document 1).

However, in a case where the inorganic filler is added, the encapsulating material may be highly viscous, deteriorating workability of the casting. In addition, in a case where the inorganic filler settles during curing, a difference in linear expansion coefficient between an upper surface and a lower surface of a cured product occurs, making cracks more likely to form in the cured product of the encapsulating resin, which can reduce reliability of the resulting device.

### RELATED DOCUMENT

### PATENT DOCUMENT

[Patent Document 1] Japanese Unexamined Patent Publication No. 2009-67890

### SUMMARY OF THE INVENTION

### TECHNICAL PROBLEM

The present invention has been made in view of the above-described problems, and an object of the present invention is to provide a liquid resin composition for encapsulating a power semiconductor element, which has low viscosity and in which sedimentation of an inorganic filler during storage is reduced, thereby ensuring excellent workability of casting, reducing sedimentation of the inorganic filler during curing, and exhibiting excellent heat resistance; and is to provide a power device containing the liquid resin composition as an encapsulating material, which has excellent crack resistance, electrical properties, mechanical properties, and heat resistance.

### SOLUTION TO PROBLEM

According to the present invention, the following liquid resin composition and power device are provided.
[1] A liquid resin composition used for encapsulating, by a casting method, a power module which includes a substrate for a power module, over which a circuit layer is formed, and a power semiconductor element mounted over the circuit layer of the substrate for a power module, the liquid resin composition containing:
   (A) an epoxy resin;
   (B) an acid anhydride;
   (C) a curing accelerator;
   (D) an inorganic filler; and
   (E) a sedimentation preventing agent,

   in which the epoxy resin (A) includes an alicyclic epoxy resin, and
   a viscosity of the liquid resin composition at 25°C is 75 Pa·s or less.
[2] The liquid resin composition according to the item [1],
   in which a content of the inorganic filler (D) is 65% by mass or more and 85% by mass or less with respect to a total solid content of the liquid resin composition.
[3] The liquid resin composition according to the item [1] or [2], further containing:
   core-shell type rubber particles.
[4] The liquid resin composition according to the item [3],
   in which a content of the core-shell type rubber particles is 0.1% by mass or more and 10% by mass or less with respect to a total solid content of the liquid resin composition.
[5] The liquid resin composition according to any one of the items [1] to [4], further containing:
   a flame retardant.
[6] The liquid resin composition according to any one of the items [1] to [5],
   in which a flow distance obtained under the following condition is 20 mm or more,
   condition: 0.05 ml of the liquid resin composition is applied onto a glass plate with a diameter of the liquid resin composition of 1 cm or less, the glass plate is held at an inclination angle of 45° and a temperature of 60°C for 3 minutes, and a distance over which the liquid resin composition has flowed is defined as the flow distance (mm).
[7] The liquid resin composition according to any one of the items [1] to [6],
   in which an amount of the alicyclic epoxy resin included in the epoxy resin (A) is 75% by mass or more with respect to an entire epoxy resin (A).
[8] The liquid resin composition according to any one of the items [1] to [7],
   in which the epoxy resin (A) further includes a liquid bisphenol A-type epoxy resin or a liquid bisphenol F-type epoxy resin.
[9] The liquid resin composition according to the item [8],
   in which an amount of the liquid bisphenol A-type epoxy resin or the liquid bisphenol F-type epoxy resin included in the epoxy resin (A) is 25% by mass or less with respect to an entire epoxy resin (A).
[10] The liquid resin composition according to any one of the items [1] to [9],
   in which the acid anhydride (B) includes at least one selected from methyl-5-norbornene-2,3-dicarboxylic acid anhydride, methylcyclohexane-1,2-dicarboxylic acid anhydride, or methyltetrahydrophthalic acid anhydride.
[11] The liquid resin composition according to the item [10],
   in which a viscosity of the methyltetrahydrophthalic acid anhydride at 25°C is 30 mPa·s or more and 50 mPa·s or less.
[12] The liquid resin composition according to any one of the items [1] to [11],
   in which the curing accelerator (C) includes an organic acid salt of diazabicycloundecene.
[13] The liquid resin composition according to any one of the items [1] to [12],
   in which the sedimentation preventing agent (E) includes bentonite or polyhydroxycarboxylic acid ester.
[14] A resin-encapsulated power module including:
   a substrate for a power module, over which a circuit layer is formed;
   a power semiconductor element mounted over the circuit layer of the substrate for a power module; and
   an encapsulating material covering the substrate for a power module and the power semiconductor element,
   in which the encapsulating material consists of a cured product of the liquid resin composition according to any one of the items [1] to [13].

### ADVANTAGEOUS EFFECTS OF INVENTION

According to the present invention, there are provided a liquid resin composition for encapsulating a power semiconductor element, which has low viscosity and has excellent workability of casting, reduces sedimentation of an inorganic filler during curing, and has excellent heat resistance; and a power device containing the liquid resin composition as an encapsulating material, which has excellent crack resistance, electrical properties, mechanical properties, and heat resistance.

### DESCRIPTION OF EMBODIMENTS

Hereinafter, embodiments of the present invention will be described.

In the present specification, a numerical range indicated by "to" includes numerical values before and after "to" as the minimum value and the maximum value, respectively. In the numerical range described in stages in the present specification, the upper limit value or the lower limit value of a numerical range at one stage can be combined with the upper limit value or the lower limit value of a numerical range at another stage as appropriate. In the numerical range described in the present specification, the upper limit value or the lower limit value of the numerical range may be replaced with a value described in Examples. "A or B" means that either A or B may be included, or both A and B may be included. Materials exemplified in the present specification can be used alone or in combination of two or more kinds thereof, unless otherwise specified. In the present specification, the content of each component in the composition refers to the total amount of all substances corresponding to that component present in the composition, unless otherwise specified.

### [Liquid resin composition]

The resin composition according to the present embodiment is a liquid resin composition for casting used for encapsulating a power semiconductor element. More specifically, the resin composition according to the present embodiment is used for encapsulating, by a casting method, a power module which includes a substrate for a power module, over which a circuit layer is formed, and a power semiconductor element mounted over the circuit layer of the substrate for a power module.

The liquid resin composition for casting a power module according to the present embodiment (hereinafter, may be simply referred to as "resin composition") contains (A) an epoxy resin, (B) an acid anhydride, (C) a curing accelerator, (D) an inorganic filler, and (E) a sedimentation preventing agent. In the present embodiment, the epoxy resin (A) includes an alicyclic epoxy resin. In addition, a viscosity of the resin composition according to the present embodiment at 25°C is 75 Pa·s or less.

The resin composition according to the present embodiment has a viscosity of 75 Pa·s or less at 25°C. As a result, workability of casting is excellent. In addition, the resin composition according to the present embodiment contains the above-described components (A) to (E), and the epoxy resin (A) includes an alicyclic epoxy resin. By using the alicyclic epoxy resin, the resulting resin composition has excellent heat resistance.

Hereinafter, components used in the resin composition according to the present embodiment will be described in detail.

### (Epoxy resin (A))

The epoxy resin (A) contained in the resin composition according to the present embodiment includes an alicyclic epoxy resin. By using the alicyclic epoxy resin, a cured product of the resin composition to be obtained has a high glass transition temperature of 200°C or higher, thereby exhibiting sufficient heat resistance to be used as an encapsulating material for a power module.

As the alicyclic epoxy resin used in the present embodiment, a liquid alicyclic epoxy resin at 25°C is preferably used, and examples of such a liquid alicyclic epoxy resin include epoxy-[epoxy-oxaspiro C₈₋₁₅ alkyl]-cyclo C₅₋₁₂ alkanes such as vinylcyclopentadiene dioxide, vinylcyclohexene monoxide, vinylcyclohexene dioxide, dicyclopentadiene oxide, and 3,4-epoxy-1-[8,9-epoxy-2,4-dioxaspiro[5.5]undecan-3-yl]-cyclohexane; epoxy C₅₋₁₂ cycloalkyl C₁₋₃ alkyl-epoxy C₅₋₁₂ cycloalkane carboxylates such as 3,4-epoxycyclohexylmethyl-3',4'-epoxycyclohexane carboxylate and 4,5-epoxycyclooctylmethyl-4',5'-epoxycyclooctane carboxylate; and bis(C₁₋₃ alkyl-epoxy C₅₋₁₂ cycloalkyl C₁₋₃ alkyl) dicarboxylates such as bis(2-methyl-3,4-epoxycyclohexylmethyl) adipate. Examples of a commercially available product of the 3,4-epoxycyclohexylmethyl-3',4'-epoxycyclohexane carboxylate include trade name: CELLOXIDE #2021P (epoxy equivalent: 128 to 140) manufactured by Daicel Corporation, which is preferably used.

An amount of the alicyclic epoxy resin included in the epoxy resin (A) is, for example, 70% by mass or more, preferably 75% by mass or more and more preferably 80% by mass or more with respect to the entire epoxy resin (A).

In a preferred embodiment, the epoxy resin (A) includes a bisphenol A-type epoxy resin or a bisphenol F-type epoxy resin, in addition to the above-described alicyclic epoxy resin. By using these epoxy resins, the heat resistance of the cured product of the resin composition to be obtained can be further improved, and insulation reliability can be enhanced.

In a case where the epoxy resin (A) includes a bisphenol A-type epoxy resin or a bisphenol F-type epoxy resin, an amount thereof is, for example, 30% by mass or less, preferably 25% by mass or less and more preferably 20% by mass or less with respect to the entire epoxy resin (A).

The epoxy resin (A) may include other epoxy resins different from the above-described epoxy resins, within the range that does not impair the physical properties such as heat resistance and insulating properties of the cured product of the resin composition to be obtained. Examples of the other epoxy resins include bisphenol-type epoxy resins such as a bisphenol E-type epoxy resin, a bisphenol S-type epoxy resin, a bisphenol M-type epoxy resin (4,4'-(1,3-phenylenediisopropylidene)bisphenol-type epoxy resin), a bisphenol P-type epoxy resin (4,4'-(1,4-phenylenediisopropylidene)bisphenol-type epoxy resin), and a bisphenol Z-type epoxy resin (4,4'-cyclohexydiene bisphenol-type epoxy resin); novolac-type epoxy resins such as a phenol novolac-type epoxy resin, a cresol novolac-type epoxy resin, a trisphenol group methane-type novolac-type epoxy resin, a tetraphenol group ethane-type novolac-type epoxy resin, and a novolac-type epoxy resin having a condensed aromatic hydrocarbon structure; biphenyl-type epoxy resins; arylalkylene-type epoxy resins such as a xylylene-type epoxy resin and a biphenylaralkyl-type epoxy resin; naphthalene-type epoxy resins such as a naphthylene ether-type epoxy resin, a naphthol-type epoxy resin, a naphthalenediol-type epoxy resin, a bifunctional to tetrafunctional epoxy-type naphthalene resin, a binaphthyl-type epoxy resin, and a naphthalene aralkyl-type epoxy resin; anthracene-type epoxy resins; phenoxy-type epoxy resins; dicyclopentadiene-type epoxy resins; norbornene-type epoxy resins; adamantane-type epoxy resins; and fluorene-type epoxy resins. In a case where these epoxy resins are used, an amount thereof is, for example, 10% by mass or less, preferably 5% by mass or less with respect to the entire epoxy resin (A).

An amount of the epoxy resin (A) in the resin composition according to the present embodiment is, for example, 2% by mass to 30% by mass, preferably 4% by mass to 25% by mass with respect to the entire resin composition. The amount of the epoxy resin (A) in the resin composition refers to the total amount of the above-described alicyclic epoxy resin and, as necessary, the bisphenol A-type epoxy resin, the bisphenol F-type epoxy resin, or the other epoxy resins.

### (Acid anhydride (B))

The resin composition according to the present embodiment contains the acid anhydride (B). The acid anhydride (B) functions as a curing agent for the epoxy resin (A). Examples of the acid anhydride (B) which can be used include dodecenyl succinic acid anhydride, polyadipic acid anhydride, polyazelaic acid anhydride, polysebacic acid anhydride, poly(ethyloctadecanedioic acid) anhydride, poly(phenylhexadecanedioic acid) anhydride, methyltetrahydrophthalic acid anhydride, methylhexahydrophthalic acid anhydride, hexahydrophthalic acid anhydride, methylhimic acid anhydride, tetrahydrophthalic acid anhydride, trialkyl tetrahydrophthalic acid anhydride, methylcyclohexenedicarboxylic acid anhydride, phthalic acid anhydride, trimellitic acid anhydride, pyromellitic acid anhydride, benzophenone tetracarboxylic acid anhydride, ethylene glycol bistrimellitate, het acid anhydride, tetrahydrophthalic acid anhydride, methyl nadic anhydride (methyl-5-norbornene-2,3-dicarboxylic acid anhydride), methylhimic anhydride (methyl-3,6-endomethylene-1,2,3,6-tetrahydrophthalic acid anhydride), 4-methylcyclohexane-1,2-dicarboxylic acid anhydride, and 5-(2,5-dioxotetrahydro-3-furanyl)-3-methyl-3-cyclohexane-1,2-dicarboxylic acid anhydride. Among these, as the acid anhydride (B), from the reason that it is easy to be uniformly mixed with other components such as the epoxy resin (A), a liquid acid anhydride at 25°C, such as methyltetrahydrophthalic acid anhydride, methylhexahydrophthalic acid anhydride, methyl-5-norbornene-2,3-dicarboxylic acid anhydride, and methylcyclohexane-1,2-dicarboxylic acid anhydride is preferably used; and particularly, methyl-5-norbornene-2,3-dicarboxylic acid anhydride, methylcyclohexane-1,2-dicarboxylic acid anhydride, or methyltetrahydrophthalic acid anhydride is more preferably used. In addition, in a case of using methyltetrahydrophthalic acid anhydride, it is preferable to use methyltetrahydrophthalic acid anhydride having a viscosity of 30 to 50 mPa·s at 25°C. By using such an acid anhydride, the obtained resin composition can achieve further reduced viscosity. Examples of a commercially available product of the acid anhydride include HN series manufactured by Showa Denko Materials Co., Ltd.

The acid anhydride (B) may be used alone or in combination of two or more kinds thereof.

From the viewpoint of workability and curing properties, a blending amount of the acid anhydride (B) in the resin composition according to the present embodiment is preferably 10% by mass to 60% by mass, and more preferably 15% by mass to 50% by mass with respect to the entire resin composition. In addition, a ratio of the total number of functional groups in the acid anhydride to the total number of epoxy groups in the epoxy resin (A) is preferably 0.7 to 1.2 and more preferably 0.8 to 1.1. By using the acid anhydride (B) in an amount within the above-described range, it is possible to improve mechanical strength and insulating properties of the cured product of the resin composition to be obtained.

### (Curing accelerator (C))

The resin composition according to the present embodiment contains the curing accelerator (C). The curing accelerator (C) promotes a reaction between the epoxy resin (A) and the acid anhydride (B) which is a curing agent. Examples of the curing accelerator (C) which can be used include tertiary amines, quaternary ammonium salts, imidazoles, organic phosphines, and Lewis acid catalysts. Among these, quaternary ammonium salts are preferably used.

Examples of the tertiary amine include trimethylamine, triethylamine, tripropylamine, tributylamine, and benzyl dimethylamine.

Examples of the quaternary ammonium salt include organic acid salts of diazabicycloundecene, such as octylate of DBU [1,8-diazabicyclo[5.4.0]undecene-7] (manufactured by San-Apro Ltd., trade name: SA102), quaternary ammonium salts DBN [1,5-diazabicyclo[4.3.0]-5-nonene], a tertiary amine, and a carboxylic acid (manufactured by San-Apro Ltd., trade name: U-CAT2313), octadecyltrimethylammonium chloride (manufactured by NOF CORPORATION, trade name: Nissan Cation), and tetraalkyl (number of carbon atoms in each alkyl group: 1 to 18) ammonium salts (for example, tetraethylammonium bromide, tetrabutylammonium bromide, and tetraalkylammonium carboxylate salts (number of carbon atoms in the carboxylic acid: 1 to 12)).

Examples of the imidazoles include 1-benzyl-2-methylimidazole, 2-ethyl-4-methylimidazole, 2-undecylimidazole, 1,2-dimethylimidazole, and 1-benzyl-2-phenylimidazole.

Examples of the organic phosphine include triphenylphosphine, triphenylphosphine-triphenylborate, tris(p-methoxyphenyl) phosphine, and tetraphenylphosphonium tetraphenylborate.

Examples of the Lewis acid catalyst include boron trifluoride amine complex, boron trichloride amine complex, and boron trifluoride ethylamine complex.

These compounds may be used alone or in combination of two or more kinds thereof.

A blending amount of the curing accelerator (C) in the resin composition according to the present embodiment is, for example, 0.03% by mass or more, preferably 0.05% by mass or more and more preferably 0.08% by mass or more with respect to the entire resin composition. As a result, the curing properties of the resin composition can be improved. On the other hand, the upper limit value of the content of the curing accelerator (C) is, for example, 1% by mass or less, preferably 0.8% by mass or less, and more preferably 0.5% by mass or less with respect to the entire resin composition. As a result, the workability of casting can be improved.

### (Inorganic filler (D))

The resin composition according to the present embodiment contains the inorganic filler (D). Examples of the inorganic filler (D) include silica fillers such as quartz, fumed silica, precipitated silica, anhydrous silicic acid, molten silica, crystalline silica, and ultrafine powder amorphous silica; alumina, zircon, iron oxide, zinc oxide, titanium oxide, silicon nitride, boron nitride, aluminum nitride, silicon carbide, glass fiber, glass flake, alumina fiber, carbon fiber, mica, graphite, carbon black, ferrite, diatomaceous earth, white earth, clay, talc, aluminum hydroxide, magnesium hydroxide, calcium carbonate, manganese carbonate, magnesium carbonate, barium sulfate, potassium titanate, calcium silicate, inorganic balloon, and silver powder. These compounds may be used alone, or in combination of two or more kinds thereof. In addition, the inorganic filler may be subjected to a surface treatment. Examples of the surface treatment include alkylation treatment, trimethylsilylation treatment, silicone treatment, and a treatment with a silane coupling agent, but the surface treatment is not particularly limited.

By using the inorganic filler (D), the viscosity of the resin composition to be obtained can be adjusted to an appropriate range, and various physical properties of the cured product of the resin composition, such as strength, hardness, elastic modulus, thermal expansion, thermal conductivity, heat dissipation, and electrical properties, can be improved.

Among the above-described inorganic fillers (D), it is preferable to use a silica filler. The silica filler refers to a silica-based filler such as quartz, fumed silica, precipitated silica, anhydrous silicic acid, molten silica, crystalline silica, and ultrafine powder amorphous silica.

In a typical resin composition, in a case where the amount of filler added is increased, the viscosity of the resin composition containing the filler increases significantly. From the viewpoint of viscosity control, a shape thereof is preferably spherical rather than fibrous or amorphous. Here, the term "spherical" means that the shape may be a true sphere, an ellipse, or an approximately spherical shape including an egg shape, and specifically, an aspect ratio (a ratio of a major axis to a minor axis) is usually 1.3 or less, preferably 1.2 or less and more preferably 1.1 or less.

Furthermore, from the viewpoint of blending, it is preferable that the filler has a hydroxyl group on a surface. By having a hydroxyl group, polarity of the surface of the filler can be improved, which making it easier to mix with organic polymers having higher polarity compared to inorganic materials.

In addition, the amount of filler added can also be increased by controlling a particle size distribution. That is, by mixing fillers with different particle sizes, a higher filling rate can be achieved.

An average particle diameter of the filler is measured using (Particle Size Analyzer CILAS 1064), and is preferably 0.1 µm or more and more preferably 1 µm or more. In addition, the average particle diameter of the filler is preferably 100 µm or less and more preferably 50 µm or less.

A blending amount of the inorganic filler (D) in the resin composition according to the present embodiment is, for example, 65% by mass to 85% by mass with respect to the entire resin composition. The lower limit value of the blending amount of the inorganic filler (D) is preferably 68% by mass or more, more preferably 70% by mass or more, and still more preferably 75% by mass or more with respect to the entire resin composition. The upper limit value of the blending amount of the inorganic filler (D) is preferably 82% by mass or less, and more preferably 80% by mass or less with respect to the entire resin composition. By using the inorganic filler (D) in an amount within the above-described range, the obtained resin composition has an appropriate viscosity for casting, thereby exhibiting excellent workability of casting. Additionally, the cured product of the resin composition has low thermal expansion and high heat resistance. As a result, the curing properties of the resin composition can be improved.

### (Sedimentation preventing agent (E))

The resin composition according to the present embodiment contains the sedimentation preventing agent (E). By using the sedimentation preventing agent (E), sedimentation of the inorganic filler (D) in the resin composition can be suppressed. Examples of the sedimentation preventing agent (E) used include fine particle silica, asbestos powder, acicular magnesium, polyhydroxycarboxylic acid ester, synthetic wax, ultrafine precipitated calcium carbonate, clay, talc, organic bentonite, metal soaps, plant-based polymer oil, and polyethylene oxide-based surfactant.

A blending amount of the sedimentation preventing agent (E) in the resin composition according to the present embodiment is, for example, 0.01% by mass to 1.00% by mass with respect to the entire resin composition. The lower limit value of the blending amount of the sedimentation preventing agent (E) is preferably 0.05% by mass or more, and more preferably 0.10% by mass or more with respect to the entire resin composition. The upper limit value of the blending amount of the sedimentation preventing agent (E) is preferably 0.80% by mass or less, and more preferably 0.50% by mass or less with respect to the entire resin composition. By using the sedimentation preventing agent (E) in an amount within the above-described range, the obtained resin composition can suppress the sedimentation of the filler during storage and curing, while maintaining an appropriate viscosity and fluidity for workability of casting.

### (Core-shell type rubber particles)

The resin composition according to the present embodiment may contain core-shell type rubber particles. By using the core-shell type rubber particles, it is possible to reduce a flexural modulus of the cured product without a significant increase in viscosity of the liquid resin composition. Therefore, it is possible to obtain a resin composition which has favorable workability and is capable of forming a cured product with high strength and low elastic modulus.

The core-shell type rubber particles refer to rubber particles coated with a shell component over a part or all of a surface of a particulate core component by graft-polymerizing a polymer different from the core component over the surface of the particulate core component including a crosslinked rubber-like polymer as a main component.

Examples of the above-described core component include crosslinked rubber particles. Examples of the crosslinked rubber particles include a diene-based rubber, an acrylic rubber, and a polysiloxane-based rubber. More specific examples thereof include a butadiene rubber, an acrylic rubber, a silicone rubber, a butyl rubber, a nitrile rubber, a styrene rubber, a synthetic natural rubber, and an ethylene-propylene rubber.

Examples of the shell component include a diene-based rubber, an acrylic rubber, and a polysiloxane-based rubber. Preferred examples thereof include a polymer obtained by polymerizing one monomer or a plurality of monomers selected from the group consisting of an acrylic acid ester, a methacrylic acid ester, and an aromatic vinyl compound. The shell component is preferably graft-polymerized over the core component and chemically bonded to a polymer forming the core component. In a case where a crosslinked rubber-like polymer formed of a polymer of styrene and butadiene is used as the core component, methyl methacrylate, which is a methacrylic acid ester, and the polymer of styrene, which is an aromatic vinyl compound, are preferably used as the shell component.

Examples of a commercially available product of the core-shell type rubber particles include "PARALOID (registered trademark)" EXL-2655 (manufactured by Kureha Corporation) formed of a copolymer of butadiene, alkyl methacrylate, and styrene; "STAFILOID (registered trademark)" AC-3355 and TR-2122 (manufactured by Ganz Chemical Co., Ltd.) formed of a copolymer of an acrylic acid ester and a methacrylic acid ester; "PARALOID (registered trademark)" EXL-2611 and EXL-3387 (manufactured by Rohm & Haas Co., Ltd.) formed of a copolymer of butyl acrylate and methyl methacrylate; and "KaneAce (registered trademark)" MX Series (manufactured by Kaneka Corporation).

The core-shell type rubber particles can also be obtained as a masterbatch type epoxy resin in which the core-shell type rubber particles are pre-dispersed in an epoxy resin, and examples of such a core-shell type rubber particle-dispersed epoxy resin include "KaneAce (registered trademark)" (manufactured by Kaneka Corporation) and "ACRYSET (registered trademark) BP series" (manufactured by NIPPON SHOKUBAI CO., LTD.) .

By using such a masterbatch type core-shell type rubber particle-dispersed epoxy resin, the dispersion state of the core-shell type rubber particles in the obtained resin composition can be improved.

As a commercially available product of the core-shell type rubber particle-dispersed epoxy resin, MX series of KaneAce manufactured by Kaneka Corporation, such as MX-113, MX-120, MX-125, MX-128, MX-130, MX-135, MX-136, MX-156, MX-153, MX-257, MX-150, MX-154, MX-960, MX-170, MX-267, MX-965, MX-217, MX-416, MX-451, MX-553, MX-710, and MX-714, can be used.

From the viewpoint of obtaining a resin composition capable of forming a cured product with high strength and low elastic modulus, a content of the core-shell type rubber particles is preferably 0.1% to 10% by mass, and more preferably 0.5% to 5% by mass with respect to the total solid content of the resin composition.

In addition, from the viewpoint of obtaining a resin composition capable of forming a cured product with high strength and low elastic modulus, an average particle diameter of primary particles of the core-shell type rubber particles is preferably in a range of 50 to 500 nm and more preferably in a range of 50 to 300 nm.

The resin composition according to the present embodiment may contain a flame retardant. By using the flame retardant, it is possible to obtain a resin composition capable of forming a cured product with high flame retardancy. Examples of the flame retardants which can be used in the resin composition according to the present embodiment include aluminum hydroxide, magnesium hydroxide, zinc borate, zinc molybdate, antimony trioxide, antimony pentoxide, phosphazene, brominated epoxy resin, and brominated polycarbonate. The flame retardant may be used alone or in combination of two or more kinds thereof.

In a case of using the flame retardant, an amount thereof is, for example, 1% to 50% by mass, preferably 5% to 30% by mass with respect to the entire resin composition. By using the flame retardant in an amount within the above-described range, the obtained liquid resin composition can maintain appropriate viscosity and fluidity for workability of casting, while improving the flame retardancy of the obtained cured product.

### (Coupling agent)

The resin composition according to the present embodiment may contain a coupling agent. By using the coupling agent, compatibility between the epoxy resin (A) and the inorganic filler (D) can be enhanced.

Examples of the coupling agent which can be used include silane coupling agents such as epoxy silane, amino silane, ureido silane, and mercapto silane.

Examples of the above-described epoxy silane include γ-glycidoxypropyltriethoxysilane, γ-glycidoxypropyltrimethoxysilane, γ-glycidoxypropylmethyldimethoxysilane, and β-(3,4-epoxycyclohexyl)ethyltrimethoxysilane. In addition, examples of the amino silane include γ-aminopropyltriethoxysilane, γ-aminopropyltrimethoxysilane, N-β-(aminoethyl)γ-aminopropyltrimethoxysilane, N-β-(aminoethyl)γ-aminopropylmethyldimethoxysilane, N-phenyl-γ-aminopropyltriethoxysilane, N-phenyl-γ-aminopropyltrimethoxysilane, N-β-(aminoethyl)-γ-aminopropyltriethoxysilane, N-(6-aminohexyl)-3-aminopropyltrimethoxysilane, and N-(3-(trimethoxysilylpropyl)-1,3-benzenedimethanamine. In addition, examples of the ureido silane include γ-ureidopropyltriethoxysilane and hexamethyldisilazane. These may be used alone or in combination of two or more thereof.

A lower limit value of a content of the coupling agent is, for example, 0.05% by mass or more, preferably 0.02% by mass or more and more preferably 0.05% by mass or more with respect to the entire resin composition. An upper limit value of the content of the coupling agent is, for example, 1% by mass or less, preferably 0.8% by mass or less and more preferably 0.6% by mass or less with respect to the entire resin composition. As a result, it is possible to suppress a decrease in interfacial strength between the epoxy resin (A) and the inorganic filler (D), thereby providing the obtained resin composition with excellent durability.

### (Other additives)

The resin composition according to the present embodiment may optionally contain a colorant such as carbon black, a defoaming agent such as a silicone defoaming agent, and the like.

### (Method for producing liquid resin composition)

A method for producing the liquid resin composition according to the present embodiment will be described in detail.

The resin composition according to the present embodiment can be produced by sufficiently adding and mixing the above-described respective components, that is, the epoxy resin (A), the acid anhydride (B), the curing accelerator (C), the inorganic filler (D), the sedimentation preventing agent (E), and the other components with each other while stirring, by a conventional method.

In one embodiment, the resin composition according to the present invention can be obtained by mixing and/or kneading a main agent component and a curing agent component. More specifically, for example, the main agent component is produced by mixing the epoxy resin (A) with a portion of the inorganic filler (D), the sedimentation preventing agent (E), and other necessary components. In addition, the curing agent component is produced by mixing the acid anhydride (B) as a curing agent with the curing accelerator (C), the remaining portion of the inorganic filler (D), the sedimentation preventing agent (E), and other necessary components. Next, the main agent component and the curing agent component can be mixed and/or kneaded using a mixing machine such as a kneader, or a kneading machine such as a roll to obtain the liquid resin composition.

### (Physical properties of liquid resin composition)

The resin composition according to the present embodiment is characterized by being liquid at 25°C, a temperature at which casting work can be easily performed and thermosetting is unlikely to proceed.

The viscosity of the liquid resin composition according to the present embodiment, containing the above-described components, at 25°C is 75 Pa·s or less, preferably 70 Pa·s or less, more preferably 65 Pa·s or less, still more preferably 60 Pa·s or less, and even more preferably 55 Pa·s or less. The lower limit value of the viscosity of the resin composition at 25°C is not particularly limited, but is, for example, 5 Pa·s or more. The liquid resin composition having a viscosity within the above-described range exhibits excellent workability of casting.

In the liquid resin composition according to the present embodiment, a flow distance obtained under the following condition is preferably 20 mm or more, more preferably 25 mm or more, still more preferably 30 mm or more, and even more preferably 35 mm or more. The upper limit value of the flow distance of the resin composition is, for example, 80 mm or less. The liquid resin composition having a flow distance within the range exhibits excellent workability of casting.

(Condition) 0.05 ml of the liquid resin composition according to the present embodiment is applied onto a glass plate with a diameter of the liquid resin composition of 1 cm or less; next, the glass plate is held at an inclination angle of 45° and a temperature of 60°C for 3 minutes, and a distance over which the liquid resin composition has flowed is defined as the flow distance (mm).

### (Method of curing resin composition)

A method of heating for curing the resin composition according to the present embodiment is not particularly limited, and a known method in the related art, such as hot air circulation heating, infrared heating, and high-frequency heating, can be adopted. Heat treatment conditions are not particularly limited as long as the resin composition can be brought to a desired cured state, and for example, a temperature of 100°C to 200°C can be adopted.

### (Physical properties of cured product of resin composition)

The cured product of the liquid resin composition according to the present embodiment has a glass transition temperature of 180°C or higher, preferably 190°C or higher, more preferably 200°C or higher, still more preferably 205°C or higher, and particularly preferably 210°C or higher. As a result, the cured product of the liquid resin composition has excellent heat resistance, and accordingly, the cured product can be suitably used as an encapsulating material for a power module. The upper limit value of the glass transition temperature of the cured product of the resin composition according to the present embodiment is, for example, 250°C or lower.

The cured product of the liquid resin composition according to the present embodiment has a linear expansion coefficient of 25 ppm/K or less, preferably 20 ppm/K or less and more preferably 15 ppm/K or less. As a result, the cured product of the liquid resin composition has excellent crack resistance. The lower limit value of the linear expansion coefficient of the cured product of the liquid resin composition according to the present embodiment is, for example, 10 ppm/K or more.

A flexural modulus of the cured product of the liquid resin composition according to the present embodiment at 25°C is, for example, 20 GPa or less, preferably 18 GPa or less and more preferably 16 GPa or less. The lower limit value of the flexural modulus of the cured product of the resin composition according to the present embodiment at 25°C is, for example, 10 GPa or more.

### [Power module]

Since the cured product of the resin composition according to the present embodiment has low thermal expansion at high temperatures and high heat resistance, the cured product is suitably used as an encapsulating material for a power module. Examples of the power module include rectifiers, frequency converters, regulators, and inverters. The resin composition according to the embodiment of the present invention has fluidity as a resin composition, and thus has favorable workability of casting. In addition, since the cured product of the resin composition according to the present embodiment has a low coefficient of linear expansion, the cured product can be suitably used for the power module of a wide range of sizes. The cured product can be used in power modules for home appliances, computers, and the like, as well as in large power modules for automobiles, railway vehicles, substations, and the like.

The power module according to the present embodiment can be obtained by mounting a power semiconductor element over a substrate for a power module, over which a circuit layer is formed, and then casting and curing the above-described resin composition so as to cover the substrate and the power semiconductor element. It is preferable to perform vacuum defoaming of the resin composition during and/or before and after the casting. By performing the vacuum defoaming, air and the like, contained in the resin composition, are removed, resulting in a resin-encapsulated power module with minimal voids in the cured product of the resin composition. The power module according to the present embodiment includes the above-described cured product of the resin composition as an encapsulating material, thereby providing excellent reliability.

The embodiments of the present invention have been described above, but these are examples of the present invention and various configurations other than the above can be adopted.

### [EXAMPLES]

Hereinafter, the present invention will be described with reference to Examples and Comparative Examples, but the present invention is not limited thereto.

Each raw material used in Examples and Comparative Examples is as follows.

### <(A) Epoxy resin>

· Epoxy resin 1: alicyclic epoxy resin (manufactured by Daicel Corporation, CELLOXIDE 2021P)
· Epoxy resin 2: bisphenol A-type epoxy resin (manufactured by Mitsubishi Chemical Corporation, jER 828EL)

### <(B) Acid anhydride (curing agent)>

· Acid anhydride 1: methyl nadic acid anhydride (manufactured by Showa Denko Materials Co., Ltd., MHAC-P)
· Acid anhydride 2: methylhexahydrophthalic acid anhydride (manufactured by Showa Denko Materials Co., Ltd., HN-5500)
· Acid anhydride 3: methyltetrahydrophthalic acid anhydride (manufactured by Showa Denko Materials Co., Ltd., HN-2000)

### <(C) Curing accelerator>

· Curing accelerator 1: DBU-octylate (manufactured by San-Apro Ltd., U-CAT SA102)
· Curing accelerator 2: DBU-phenol salt (manufactured by San-Apro Ltd., U-CAT SA1)

### <(D) Inorganic filler>

· Inorganic filler 1: spherical molten silica (manufactured by Denka Company Limited., FB-950, volume average particle size: 23 µm)

### <(E) Sedimentation preventing agent >

· Sedimentation preventing agent 1: organic bentonite (manufactured by HOJUN.,Co. Ltd., S-BEN N-400)
· Sedimentation preventing agent 2: polyhydroxycarboxylic acid ester (manufactured by BYK Chemie Japan, BYK-R606)

### <(F) Flame retardant>

· Flame retardant 1: brominated epoxy resin (manufactured by DIC Corporation, EPICLON 153)
· Flame retardant 2: antimony trioxide (manufactured by NIHON SEIKO CO., LTD., PATOX-K)
· Flame retardant 3: aluminum hydroxide (manufactured by Sumitomo Chemical Co., Ltd., CWL-325J)

### <Other additives>

· Low stress agent 1: core-shell type rubber particles (manufactured by Kaneka Corporation, MX-553; core-shell type rubber particle-dispersed epoxy resin in which alicyclic epoxy resin (CELLOXIDE 2021P); core-shell type rubber particles is 7:3 (in mass ratio))
· Colorant 1: carbon black (manufactured by Mitsubishi Chemical Corporation, Carbon #5)
· Coupling agent 1: epoxy silane coupling agent (manufactured by Momentive Performance Materials Inc., A-187)
· Defoaming agent 1: silicone defoaming agent (manufactured by Shin-Etsu Chemical Co., Ltd., KS603)

### (Examples 1 to 20 and Comparative Examples 1 and 2)

### <Production of liquid resin composition>

Components shown in "Main agent" of Table 1 were mixed with each other in amounts shown in Table 1 to obtain a main agent (I). Separately, components shown in "Curing agent" of Table 1 were mixed with each other in amounts shown in Table 1 to obtain a curing agent (II). 100 parts by mass of the above-described main agent (I) and 100 parts by mass of the above-described curing agent (II) were mixed to produce a liquid resin composition.

### <Evaluation of physical properties of liquid resin composition>

Physical properties of the liquid resin compositions obtained in each of Examples and Comparative Examples were measured as follows. The results are shown in Table 1.

### (Viscosity at 25°C)

The viscosity of the liquid resin composition was measured using an E-type viscometer with rotor No. 4, at a rotation speed of 10 rpm, a temperature of 25°C, and a measurement time of 1 minute. The results are shown in Table 1.

### (Fluidity)

0.05 ml of the liquid resin composition was applied onto a glass plate with a diameter of the liquid resin composition of 1 cm or less. Next, the glass plate was held at an inclination angle of 45° and a temperature of 60°C for 3 minutes, and a distance over which the liquid resin composition had flowed was measured as a flow distance (mm). The flow distances are shown in Table 1.

### (Storage stability)

Storage stability of the main agent (I) and the curing agent (II) was evaluated using the following method.

First, the main agent (I) was placed into a 120 mL plastic container with a lid to a height of 50 to 55 mm, the lid was closed, and a height of filler sedimentation (hard cake) deposited at the bottom after being kept at 60°C for 24 hours was measured. In Table 1, the height of the hard cake was evaluated as follows: 0 mm was rated as "A", more than 0 mm and less than 3 mm was rated as "B", and 3 mm or more was rated as "C".

The curing agent (II) was also evaluated for storage stability in the same manner as the main agent (I). The results are shown in Table 1.

### (Workability of casting)

The workability of casting of the liquid resin composition was evaluated based on the following evaluation criteria.
A: all of the following (Requirement 1) to (Requirement 3) were satisfied.
B: any two of the following (Requirement 1) to (Requirement 3) were satisfied.
C: any one of the following (Requirement 1), (Requirement 2), or (Requirement 3) was satisfied, or none of the following (Requirement 1), (Requirement 2), and (Requirement 3) was satisfied.

Requirement 1: the above-described viscosity of the liquid resin composition at 25°C was 75 Pa·s or less.

Requirement 2: the above-described flow distance in the evaluation of the fluidity of the liquid resin composition was 30 mm or more.

Requirement 3: the results of the above-described storage stability evaluation were "A" for both the main agent (I) and the curing agent (II).

### <Evaluation of physical properties of cured product of resin>

The following physical properties were measured for a cured product obtained by curing the liquid resin composition from each of Examples and Comparative Examples.

### (Glass transition temperature)

The liquid resin composition was casted into an aluminum cup, and cured at 160°C for 1 hour, followed by 180°C for 2 hours. The cured substance was slowly cooled to room temperature, and cut to dimensions of 10 mm × 5 mm × 5 mm to obtain a test piece. The test piece was subjected to a measurement using a thermomechanical analyzer (manufactured by Hitachi High-Tech Science Corporation, TMA7100) under the conditions of a measurement temperature range of 0°C to 320°C and a temperature rising rate of 10 °C/min. Next, the glass transition temperature (°C) was calculated from the measurement results. As the glass transition temperature increases, the heat resistance of the cured product is excellent.

### (Linear expansion coefficient)

The cured product of the resin composition obtained in each of Examples was set in a thermomechanical analyzer (manufactured by Hitachi High-Tech Science Corporation, TMA7100), and subjected to a measurement under the conditions of a temperature range of 0°C to 320°C and a temperature rising rate of 10 °C/min. The measurement data was analyzed to obtain an average linear expansion coefficient in a temperature range of 50°C to 70°C. The unit of the average linear expansion coefficient is [ppm/K]. As the value of the average linear expansion coefficient is smaller, expansion property of the cured product is lower.

### (Flexural modulus)

The resin composition obtained in each of Examples was poured into a mold with an opening of 4 mm in width, 100 mm in length, and 120 mm in height, and cured at 160°C for 1 hour, followed by 180°C for 2 hours. The cured substance was slowly cooled to room temperature and cut to dimensions of 4 mm × 10 mm × 100 mm, and a flexural modulus at 25°C was measured in accordance with JIS 6911. As the value of flexural modulus is smaller, elasticity of the cured product is lower.

### (Flame retardancy)

The resin composition obtained in Examples 16 to 20 was poured into a mold with an opening of 1.5 to 6.0 mm in width, 100 mm in length, and 140 mm in height, and cured at 160°C for 1 hour, followed by 180°C for 2 hours. The cured substance was slowly cooled to room temperature, cut to dimensions of 1.5 to 6.0 mm × 12.5 mm × 125 mm, and evaluated based on a burning time according to the UL-94 vertical test. In Table 1, the maximum burning time of 10 seconds or shorter and the total burning time of 50 seconds or shorter was indicated as "V-0", and the maximum burning time of 30 seconds or shorter and the total burning time of 250 seconds or shorter was indicated as "V-1".

**Table 1**

| <Formulation of resin composition> | | | Unit | Example 1 | Example 2 | Example 3 | Example 4 | Example 5 | Example 6 | Example 7 |
|---|---|---|---|---|---|---|---|---|---|---|
| | (A) Epoxy resin | Epoxy resin 1 | Part by mass | 21 | 32 | 27 | 19 | 13 | 21 | 21 |
| | | Epoxy resin 2 | Part by mass | - | - | - | - | - | - | - |
| | (D) Inorganic filler | Inorganic filler 1 | Part by mass | 78 | 67 | 72 | 81 | 86 | 78 | 78 |
| | (E) Sedimentation preventing agent | Sedimentation preventing agent 1 | Part by mass | 0.4 | 0.8 | 0.4 | 0.3 | 0.3 | 0.4 | 0.4 |
| | | Sedimentation preventing agent 2 | Part by mass | - | - | - | - | - | - | - |
| Main agent (I) | (F) Flame retardant | Flame retardant 1 | Part by mass | - | - | - | - | - | - | - |
| | | Flame retardant 2 | Part by mass | - | - | - | - | - | - | - |
| | | Flame retardant 3 | Part by mass | - | - | - | - | - | - | - |
| | Others | Low stress agent 1 | Part by mass | - | - | - | - | - | - | - |
| | | Colorant 1 | Part by mass | 0.1 | 0.1 | 0.1 | 0.1 | 0.1 | 0.1 | 0.1 |
| | | Coupling agent 1 | Part by mass | 0.2 | 0.2 | 0.2 | 0.2 | 0.2 | 0.2 | 0.2 |
| | | Defoaming agent 1 | Part by mass | 0.1 | 0.1 | 0.1 | 0.1 | 0.1 | 0.1 | 0.1 |
| | (B) Acid anhydride | Acid anhydride 1 | Part by mass | 24 | 36 | 31 | 20 | 15 | - | 24 |
| | | Acid anhydride 2 | Part by mass | - | - | - | - | - | 28 | - |
| | | Acid anhydride 3 | Part by mass | - | - | - | - | - | - | - |
| | (C) Curing accelerator | Curing accelerator 1 | Part by mass | 0.5 | 0.7 | 0.6 | 0.4 | 0.3 | 0.1 | - |
| | | Curing accelerator 2 | Part by mass | - | - | - | - | - | - | 0.5 |
| Curing (II) | (D) Inorganic filler | Inorganic filler 1 | Part by mass | 75 | 63 | 68 | 79 | 84 | 72 | 75 |
| | (E) Sedimentation preventing agent | Sedimentation preventing agent 1 | Part by mass | 0.1 | 0.1 | 0.1 | 0.1 | 0.1 | 0.1 | 0.1 |
| | | Sedimentation preventing agent 2 | Part by mass | - | - | - | - | - | - | - |
| | Others | Defoaming agent 1 | Part by mass | 0.1 | 0.1 | 0.1 | 0.1 | 0.1 | 0.1 | 0.1 |
| Liquid resin composition | | Main agent (I) | Part by mass | 100 | 100 | 100 | 100 | 100 | 100 | 100 |
| | | Curing agent (II) | Part by mass | 100 | 100 | 100 | 100 | 100 | 100 | 100 |
| <Physical properties of liquid resin composition> | | | | | | | | | | |
| Viscosity (25°C) | | | Pa·s | 19 | 6 | 15 | 25 | 49 | 13 | 17 |
| Fluidity | | Flow distance with 45° inclination at 60°C for 3 min | mm | 46 | 74 | 50 | 38 | 25 | 71 | 40 |
| Storage stability | | Filler sedimentation of mair | | A | B | A | A | A | A | A |
| | | agent Filler sedimentation of curing agent | - | A | B | A | A | A | B | A |
| Workability of casting | | | - | A | A | A | A | B | B | A |
| <Physical properties of cured product of resin> | | | | | | | | | | |
| Glass transition temperature | | TMA method | °C | 213 | 211 | 217 | 214 | 214 | 205 | 216 |
| Linear expansion coefficient | | TMA method | ppm/K | 15 | 25 | 19 | 11 | 9 | 19 | 20 |
| Flexural modulus | | 25°C | GPa | 17 | 10 | 13 | 19 | 21 | 16 | 17 |
| Flame retardancy | | JL-94 (vertical test) | - | - | - | - | - | - | - | - |

**Table 1 (continued)**

| <Formulation of resin composition> | | | Unit | Example 8 | Example 9 | Example 10 | Example 11 | Example 12 | Example 13 | Example 14 | Example 15 |
|---|---|---|---|---|---|---|---|---|---|---|---|
| | (A) Epoxy resin | Epoxy resin 1 | Part by mass | 21 | 21 | 22 | 16 | 21 | 15 | 10 | 14 |
| | | Epoxy resin 2 | Part by mass | - | - | - | 6 | - | - | - | - |
| | (D) Inorganic (D) filler | Inorganic filler 1 | Part by mass | 78 | 78 | 78 | 77 | 78 | 77 | 76 | 75 |
| | (E) Sedimentation preventing agent | Sedimentation preventing agent 1 | Part by mass | 0.3 | 0.8 | - | 0.2 | 0.4 | 0.4 | 0.4 | 0.4 |
| | | Sedimentation preventing agent 2 | Part by mass | - | - | 0.1 | - | - | - | - | - |
| Main agent (I) | (F) Flame retardant | Flame retardant 1 | Part by mass | - | - | - | - | - | - | - | - |
| | | Flame retardant 2 | Part by mass | - | - | - | - | - | - | - | - |
| | | Flame retardant 3 | Part by mass | - | - | - | - | - | - | - | - |
| | Others | Low stress agent 1 | Part by mass | - | - | - | - | 7 | 13 | 20 | 13 |
| | | Colorant 1 | Part by mass | 0.1 | 0.1 | 0.1 | 0.1 | 0.1 | 0.1 | 0.1 | 0.1 |
| | | Coupling agent 1 | Part by mass | 0.2 | 0.2 | 0.2 | 0.2 | 0.2 | 0.2 | 0.2 | 0.2 |
| | | Defoaming agent 1 | Part by mass | 0.1 | 0.1 | 0.1 | 0.1 | 0.1 | 0.1 | 0.1 | 0.1 |
| | (B) Acid anhydride | Acid anhydride 1 | Part by mass | 24 | 24 | 24 | 23 | 23 | 22 | 21 | - |
| | | Acid anhydride 2 | Part by mass | - | - | - | - | - | - | - | - |
| | | Acid anhydride 3 | Part by mass | - | - | - | - | - | - | - | 22 |
| | Curing accelerator | Curing accelerator 1 | Part by mass | 0.6 | 0.6 | 0.6 | 0.5 | 0.5 | 0.5 | 0.4 | 0.4 |
| | | Curing accelerator 2 | Part by mass | - | - | - | - | - | - | - | - |
| (C) Curing agent (II) | (D) Inorganic filler | Inorganic filler 1 | Part by mass | 75 | 75 | 75 | 76 | 75 | 75 | 77 | 78 |
| | (E) Sedimentation agent preventing agent | Sedimentation preventing 1 | Part by mass | - | 0.2 | - | 0.1 | 0.1 | 0.1 | 0.1 | 0.1 |
| | | Sedimentation preventing agent 2 | Part by mass | - | - | 0.1 | - | - | - | - | - |
| | Others | Defoaming agent 1 | Part by mass | 0.1 | 0.1 | 0.1 | 0.1 | 0.1 | 0.1 | 0.1 | 0.1 |
| Liquid resin composition | | Main agent (I) | Part by mass | 100 | 100 | 100 | 100 | 100 | 100 | 100 | 100 |
| | | Curing agent (II) | Part by mass | 100 | 100 | 100 | 100 | 100 | 100 | 100 | 100 |
| <Physical properties of liquid resin composition> | | | | | | | | | | | |
| Viscosity (25°C) | | | Pa·s | 16 | 23 | 17 | 29 | 24 | 35 | 46 | 13 |
| Fluidity | | Flow distance with 45° inclination at 60°C for 3 min | mm | 51 | 31 | 34 | 31 | 50 | 49 | 38 | 70 |
| Storage stability | | Filler sedimentation of main agent | - | B | A | B | B | A | A | A | A |
| | | Filler sedimentation of curing agent | - | B | A | B | A | A | A | A | B |
| Workability of casting | | | - | B | A | B | B | A | A | A | B |
| <Physical properties of cured product of resin> | | | | | | | | | | | |
| Glass transition temperature | | TMA method | °C | 212 | 215 | 214 | 202 | 212 | 222 | 209 | 191 |
| Linear expansion coefficient | | TMA method | ppm/K | 18 | 19 | 20 | 18 | 16 | 14 | 14 | 13 |
| Flexural modulus | | 25°C | GPa | 17 | 18 | 17 | 17 | 15 | 13 | 12 | 13 |
| Flame retardancy | | JL-94 (vertical test) | - | - | - | - | - | - | - | - | - |

**Table 1 (continued)**

| <Formulation of resin composition> | | | Unit | Example 16 | Example 17 | Example 18 | Example 19 | Example 20 | Comparative Example 1 | Comparative Example 2 |
|---|---|---|---|---|---|---|---|---|---|---|
| | (A) Epoxy resin | Epoxy resin 1 | Part by mass | 7 | 10 | 20 | 6 | 7 | 21 | - |
| | | Epoxy resin 2 | Part by mass | - | - | - | - | - | - | 24 |
| | (D) Inorganic filler | Inorganic filler 1 | Part by mass | 61 | 46 | 49 | 16 | 56 | 78 | 75 |
| | (E) Sedimentation preventing agent | Sedimentation preventing agent 1 | Part by mass | 0.2 | 0.3 | 0.3 | 0.2 | 0.2 | - | 0.2 |
| | | Sedimentation preventing agent 2 | Part by mass | - | - | - | - | - | - | - |
| | (F) Flame retardant | Flame retardant 1 | Part by mass | 11 | - | - | - | - | - | - |
| Main agent (I) | | Flame retardant 2 | Part by mass | 3 | - | - | - | - | - | - |
| | | Flame retardant 3 | Part by mass | - | 30 | 30 | 60 | 26 | - | - |
| | Others | Low stress agent 1 | Part by mass | 17 | 13 | - | 17 | 10 | - | - |
| | | Colorant 1 | Part by mass | 0.1 | 0.1 | 0.1 | 0.1 | 0.1 | 0.1 | 0.1 |
| | | Coupling agent 1 | Part by mass | 0.2 | 0.2 | 0.2 | 0.2 | 0.2 | 0.2 | 0.2 |
| | | Defoaming agent 1 | Part by mass | 0.1 | 0.1 | 0.1 | 0.1 | 0.1 | 0.1 | 0.1 |
| | (B) Acid anhydride | 4cid anhydride 1 | Part by mass | - | - | 22 | - | 8 | 24 | 21 |
| | | Acid anhydride 2 | Part by mass | - | - | - | - | - | - | - |
| | | Acid anhydride 3 | Part by mass | 27 | 20 | - | 20 | 8 | - | - |
| | (C) Curing accelerator | During accelerator 1 | Part by mass | 0.2 | 0.1 | 0.5 | 0.1 | 0.2 | 0.5 | 0.5 |
| Curing agent (II) | | During accelerator 2 | Part by mass | - | - | - | - | - | - | - |
| | (D) Inorganic filler | Inorganic filler 1 | Part by mass | 123 | 80 | 77 | 80 | 84 | 75 | 78 |
| | (E) Sedimentation preventing agent | Sedimentation preventing agent 1 | Part by mass | 0.1 | 0.1 | 0.1 | 0.1 | 0.1 | - | 0.1 |
| | | Sedimentation preventing agent 2 | Part by mass | - | - | - | - | - | - | - |
| | Others | Defoaming agent 1 | Part by mass | 0.1 | 0.1 | 0.1 | 0.1 | 0.1 | 0.1 | 0.1 |
| Liquid resin composition | | Main agent (I) | Part by mass | 100 | 100 | 100 | 100 | 100 | 100 | 100 |
| | | During agent (II) | Part by mass | 150 | 100 | 100 | 100 | 100 | 100 | 100 |
| <Physical properties of liquid resin composition> | | | | | | | | | | |
| Viscosity (25°C) | | | Pa·s | 19 | 16 | 31 | 25 | 55 | 16 | 76 |
| Fluidity | | Flow distance with 45° inclination at 60°C for 3 nin | mm | 43 | 41 | 27 | 32 | 36 | 50 | 10 |
| Storage stability | | Filler sedimentation of main agent | - | B | A | A | A | A | C | B |
| | | Filler sedimentation of curing agent | - | B | B | A | B | A | B | A |
| Workability of casting | | | - | B | B | B | B | A | B | C |
| <Physical properties of cured product of resin> | | | | | | | | | | |
| Glass transition temperature | | TMA method | °C | 185 | 193 | 218 | 189 | 205 | 214 | 155 |
| Linear expansion coefficient | | TMA method | ppm/K | 13 | 15 | 16 | 17 | 11 | 18 | 19 |
| Flexural modulus | | 25°C | GPa | 13 | 14 | 17 | 12 | 18 | 17 | 17 |
| Flame retardancy | | JL-94 (vertical test) | - | V-0 (1.5 mmt) | V-0 (6.0 mmt) | V-0 (6.0 mmt) | V-0 (3.0 mmt) | V-1 (6.0 mmt) | - | - |

The resin composition of Examples exhibited low viscosity, thereby exhibiting excellent workability of casting. The cured product of the resin composition of Examples had a high glass transition temperature and low thermal expansion, and thus the cured product was a material excellent in heat resistance and crack resistance, which could be suitably used as an encapsulating material. Among these, particularly, the resin compositions of Examples 12 to 15, containing the core-shell type rubber particles, had low viscosity, and the cured product thereof had low elasticity. In addition, among these, the resin compositions of Examples 16 to 20, containing the flame retardant, had low viscosity and excellent handleability, and the cured product thereof had excellent flame retardancy.

This application claims priority based on Japanese application Japanese Patent Application No. 2022-090311 filed on June 2, 2022 and Japanese application Japanese Patent Application No. 2023-016277 filed on February 6, 2023, all of its disclosures are incorporated herein.

## Claims

1. A liquid resin composition used for encapsulating, by a casting method, a power module which includes a substrate for a power module, over which a circuit layer is formed, and a power semiconductor element mounted over the circuit layer of the substrate for a power module, the liquid resin composition comprising:
(A) an epoxy resin;
(B) an acid anhydride;
(C) a curing accelerator;
(D) an inorganic filler; and
(E) a sedimentation preventing agent,
wherein the epoxy resin (A) includes an alicyclic epoxy resin, and
a viscosity of the liquid resin composition at 25°C is 75 Pa·s or less.

2. The liquid resin composition according to Claim 1,
wherein a content of the inorganic filler (D) is 65% by mass or more and 85% by mass or less with respect to a total solid content of the liquid resin composition.

3. The liquid resin composition according to Claim 1 or 2, further comprising:
core-shell type rubber particles.

4. The liquid resin composition according to Claim 3,
wherein a content of the core-shell type rubber particles is 0.1% by mass or more and 10% by mass or less with respect to a total solid content of the liquid resin composition.

5. The liquid resin composition according to any one of Claims 1 to 4, further comprising:
a flame retardant.

6. The liquid resin composition according to any one of Claims 1 to 5,
wherein a flow distance obtained under the following condition is 20 mm or more,
condition: 0.05 ml of the liquid resin composition is applied onto a glass plate with a diameter of the liquid resin composition of 1 cm or less, the glass plate is held at an inclination angle of 45° and a temperature of 60°C for 3 minutes, and a distance over which the liquid resin composition has flowed is defined as the flow distance (mm).

7. The liquid resin composition according to any one of Claims 1 to 6,
wherein an amount of the alicyclic epoxy resin included in the epoxy resin (A) is 75% by mass or more with respect to an entire epoxy resin (A).

8. The liquid resin composition according to any one of Claims 1 to 7,
wherein the epoxy resin (A) further includes a liquid bisphenol A-type epoxy resin or a liquid bisphenol F-type epoxy resin.

9. The liquid resin composition according to Claim 8,
wherein an amount of the liquid bisphenol A-type epoxy resin or the liquid bisphenol F-type epoxy resin included in the epoxy resin (A) is 25% by mass or less with respect to an entire epoxy resin (A).

10. The liquid resin composition according to any one of Claims 1 to 9,
wherein the acid anhydride (B) includes at least one selected from methyl-5-norbornene-2,3-dicarboxylic acid anhydride, methylcyclohexane-1,2-dicarboxylic acid anhydride, or methyltetrahydrophthalic acid anhydride.

11. The liquid resin composition according to Claim 10,
wherein a viscosity of the methyltetrahydrophthalic acid anhydride at 25°C is 30 mPa·s or more and 50 mPa·s or less.

12. The liquid resin composition according to Claim 1,
wherein the curing accelerator (C) includes an organic acid salt of diazabicycloundecene.

13. The liquid resin composition according to any one of Claims 1 to 12,
wherein the sedimentation preventing agent (E) includes bentonite or polyhydroxycarboxylic acid ester.

14. A resin-encapsulated power module comprising:
a substrate for a power module, over which a circuit layer is formed;
a power semiconductor element mounted over the circuit layer of the substrate for a power module; and
an encapsulating material covering the substrate for a power module and the power semiconductor element,
wherein the encapsulating material consists of a cured product of the liquid resin composition according to any one of Claims 1 to 13.
